# EUROPEAN PATENT APPLICATION

(11) **EP 4 804 408 A1**
(43) Date of publication of application: **09.09.2026**
(21) Application number: 26161877.1
(22) Date of filing: 03.03.2026
(51) Int. Cl.: H03M 1/08, H03M 1/46

(54) **SYSTEMS AND METHODS FOR NOISE MITIGATION USING CHOPPING IN SIGNAL CONVERSION**

(30) Priority: 05.03.2025 US 202519070721
(71) Applicant: AVAGO TECHNOLOGIES INTERNATIONAL SALES PTE. LIMITED, Singapur 768923 (SG)
(72) Inventor: Hsu, Chia-Jen, Irvine, CA, 92620 (US); Ragab, Kareem Abdelghani Ibraheem Mohamed, Irvine, CA, 92620 (US); Ku, I-Ning, Irvine, CA, 92620 (US); Chandrasekhar, Vinay, Irvine, CA, 92602 (US); Jiang, Xicheng, Irvine, CA, 92612 (US)
(74) Representative: Grünecker Patent- und Rechtsanwälte PartG mbB

(57) **Abstract**

The subject technology is directed to signal processing systems and methods. In an embodiment, the subject technology provides an apparatus that includes an input terminal configured to receive an input signal and a converter coupled to the input terminal. The converter is configured to generate a first signal based at least on the input signal. The apparatus further includes an amplifier coupled to the converter, the amplifier being configured to generate a second signal by amplifying the first signal. A first switching element is coupled to the converter and the amplifier and is configured to perform chopping by modulating the first signal, converting a first component of the second signal to a first chopping frequency higher than the first frequency. By applying chopping techniques, the apparatus effectively mitigates low-frequency noise, enhancing the accuracy and performance of signal processing operations. There are other embodiments as well.

## Description

### FIELD OF INVENTION

The subject technology is directed to signal processing systems and methods.

### BACKGROUND OF THE INVENTION

Analog-to-digital converters (ADCs) are important components in modern electronic systems, enabling the conversion of analog signals into digital representations for processing and storage. ADCs are widely used in various applications, including health sensing devices, industrial automation, communication systems, and/or the like. As the demand for higher precision and lower power consumption increases, ADC architectures must be designed to minimize noise and maintain signal integrity across a wide range of operating conditions.

Many ADC architectures, such as successive approximation register (SAR) ADCs and noise-shaped ADCs, incorporate amplifiers and comparators to process signals during conversion. However, these components may introduce low-frequency noise, such as flicker noise, which can degrade signal quality and reduce overall system performance. In applications that require high precision and stability, such as biomedical monitoring, environmental sensing, and/or high-resolution data acquisition, even minor noise fluctuations can lead to errors that affect the reliability of the measured data.

Various approaches for mitigating low-frequency noise have been explored, but they have proven to be insufficient. It is important to recognize the need for new and improved systems and methods.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a simplified diagram illustrating an analog-to-digital conversion system according to embodiments of the subject technology.
Figure 2A is a simplified diagram illustrating an analog-to-digital converter (ADC) according to embodiments of the subject technology.
Figure 2B is a simplified diagram illustrating a signal flow within an analog-to-digital converter (ADC) according to embodiments of the subject technology.
Figure 3 is a simplified diagram illustrating an analog-to-digital conversion system according to embodiments of the subject technology.

### DETAILED DESCRIPTION OF THE INVENTION

The subject technology is directed to signal processing systems and methods. In an embodiment, the subject technology provides an apparatus that includes an input terminal configured to receive an input signal and a converter coupled to the input terminal. The converter is configured to generate a first signal based at least on the input signal. The apparatus further includes an amplifier coupled to the converter, the amplifier being configured to generate a second signal by amplifying the first signal. A first switching element is coupled to the converter and the amplifier and is configured to perform chopping by modulating the first signal, converting a first component of the second signal to a first chopping frequency higher than the first frequency. A filter is coupled to the amplifier and is configured to generate a third signal by spectrally shaping the second signal. For example, the term "filter" may refer to a circuit or device configured to shape a signal by attenuating certain frequencies while preserving others. As an example, filters may include, but are not limited to, low-pass filters, high-pass filters, band-pass filters, and/or other types of frequency-selective circuits. Filters may be implemented using passive elements, active components, or a combination thereof. A comparator coupled to the filter generates an output signal by comparing the third signal against a reference level. By applying chopping techniques, the apparatus effectively mitigates low-frequency noise, enhancing the accuracy and performance of signal processing operations. There are other embodiments as well.

As previously noted, analog-to-digital converters (ADCs) play an important role in converting analog signals into digital data for processing in a wide range of applications, such as health sensing devices, industrial automation, and communication systems. For example, the term "analog-to-digital converter" may refer to a device or circuit that converts a continuous analog signal into a discrete digital representation. Examples of ADCs may include, without limitation, successive approximation register (SAR) ADCs, discrete-time ADCs, noise-shaped SAR (NS-SAR) ADCs, delta-sigma ADCs, pipelined ADCs, flash ADCs, hybrid ADCs, dual-slope ADCs, single-slope ADCs, and/or the like. However, ADC performance is often degraded by low-frequency noise (e.g., flicker noise), which may originate from circuit components such as amplifiers and comparators. This noise introduces unwanted signal variations, leading to offset drift and reduced conversion accuracy, particularly in high-resolution and low-power applications.

Some approaches for mitigating flicker noise involve analog scaling or system-level chopping in ADCs, but these approaches introduce trade-offs that affect system performance. For instance, analog scaling reduces flicker noise by increasing the device area, but this results in higher power consumption, increased silicon area, and degraded signal-to-noise ratio (SNR) due to large parasitic capacitance at the comparator input. System-level chopping, which applies chopping at the ADC input and output, effectively upconverts noise but is not suitable for oversampled ADCs such as noise-shaped SAR (NS-SAR) ADCs. In such systems, system-level chopping may mix with quantization noise, causing high-frequency noise components to be downconverted into the signal band, which degrades the SNR and conversion efficiency.

In various embodiments, the subject technology provides systems and methods for noise mitigation in ADCs using block-level chopping. Unlike system-level chopping, which applies modulation at the ADC input and output, the subject technology applies chopping selectively within specific circuit blocks, such as the amplifier and comparator, to upconvert low-frequency noise while avoiding interference with quantization noise shaping. By localizing chopping operations to targeted circuit elements, the system reduces flicker noise without introducing unwanted signal distortions. The disclosed techniques also ensure proper synchronization between chopping and dechopping stages, preserving signal integrity while minimizing implementation overhead. This approach enables efficient flicker noise suppression and enhanced conversion accuracy, making it particularly beneficial for high-resolution ADCs, low-power sensor applications, and other precision signal processing systems.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes an apparatus, which comprises an input terminal configured to receive an input signal. The apparatus further comprises a converter coupled to the input terminal, the converter being configured to generate a first signal based at least on the input signal. The apparatus further comprises an amplifier coupled to the converter, the amplifier being configured to generate a second signal by amplifying the first signal, the second signal comprising a first component characterized by a first frequency. The apparatus further comprises a first switching element coupled to the converter and the amplifier, the first switching element being configured to modulate the first signal by converting the first component to a first chopping frequency higher than the first frequency. The apparatus further comprises a filter coupled to the amplifier, the filter being configured to generate a third signal by spectrally shaping the second signal. The apparatus further comprises a comparator coupled to the filter, the comparator being configured to generate an output signal by comparing the sum of the first and third signals to a reference level.

Implementations may include one or more of the following features. The apparatus further comprises a second switching element coupled to the amplifier, the second switching element being configured to demodulate the second signal at the first chopping frequency. The third signal comprises a second component characterized by a second frequency lower than the first chopping frequency. The apparatus further comprises a third switching element coupled to the filter and the comparator, the third switching element being configured to modulate the third signal by converting the second component to the first chopping frequency. The apparatus further comprises a fourth switching element coupled to the comparator and configured to demodulate the third signal at the first chopping frequency. The fourth switching element comprises a multiplexer. The apparatus further comprises a controller coupled to the comparator, the controller being configured to generate a digital representation of the input signal based at least on the output signal. The first signal is associated with a difference between the input signal and a first approximation of the input signal. The filter further comprises an integrator configured to accumulate the second signal over one or more cycles.

According to another embodiment, the subject technology provides an apparatus that comprises an input terminal configured to receive an input signal. The apparatus further comprises a converter coupled to the input terminal, the converter being configured to generate a first signal based at least on the input signal. The apparatus further comprises an amplifier coupled to the converter, the amplifier being configured to generate a second signal by amplifying the first signal, the second signal comprising a first component characterized by a first frequency. The apparatus further comprises a first switching element coupled to the converter and the amplifier, the first switching element being configured to modulate the first signal by converting the first component to a first chopping frequency higher than the first frequency. The apparatus further comprises a filter coupled to the amplifier, the filter being configured to generate a third signal based at least on the second signal. The apparatus further comprises a comparator coupled to the filter, the comparator being configured to generate an output signal by comparing the sum of the first and third signals to a reference level.

Implementations may include one or more of the following features. The apparatus further comprises a second switching element coupled to the amplifier, the second switching element being configured to demodulate the second signal at the first chopping frequency. The third signal comprises a second component characterized by a second frequency lower than the first chopping frequency. The apparatus further comprises a third switching element coupled to the filter and the comparator, the third switching element being configured to modulate the third signal by converting the second component to the first chopping frequency. The apparatus further comprises a fourth switching element coupled to the comparator and configured to demodulate the third signal at the first chopping frequency. The apparatus further comprises a controller coupled to the comparator, the controller being configured to generate a digital representation of the input signal based at least on the output signal. The first signal is associated with a difference between the input signal and a first approximation of the input signal.

According to yet another embodiment, the subject technology provides an apparatus, which comprises an input terminal configured to receive an input signal. The apparatus further comprises a converter coupled to the input terminal, the converter being configured to generate a first signal based at least on the input signal. The apparatus further comprises an amplifier coupled to the converter, the amplifier being configured to generate a second signal by amplifying the first signal, the second signal comprising a first component characterized by a first frequency. The apparatus further comprises a first switching element coupled to the converter and the amplifier, the first switching element being configured to modulate the first signal by converting the first component to a first chopping frequency higher than the first frequency. The apparatus further comprises a filter coupled to the amplifier, the filter being configured to generate a third signal based at least on the second signal. The apparatus further comprises a comparator coupled to the filter, the comparator being configured to generate an output signal by comparing the sum of the first and third signals to a reference level. The apparatus further comprises a second switching element coupled to the comparator and configured to demodulate the third signal at the first chopping frequency. In various embodiments, the apparatus further comprises a controller coupled to the comparator, the controller being configured to generate a digital representation of the input signal based at least on the output signal. The second switching element comprises a multiplexer.

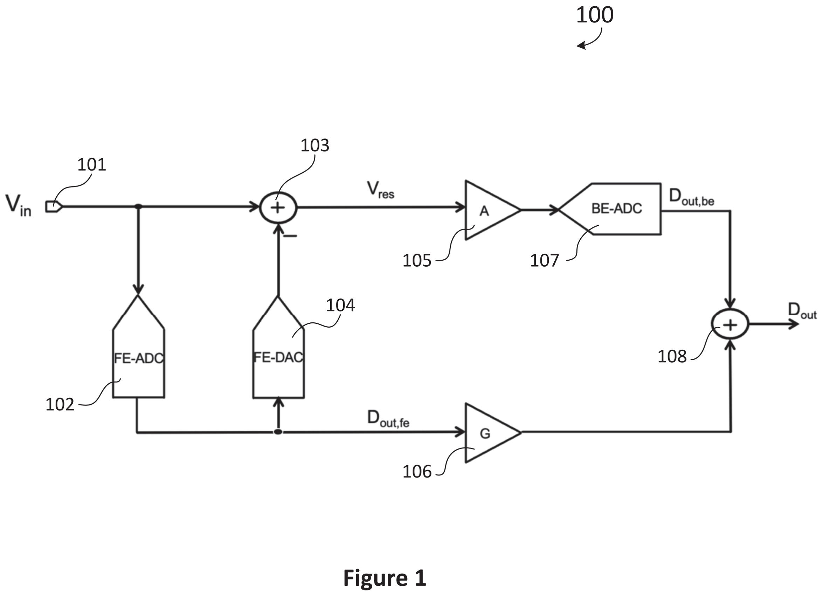

Figure 1 is a simplified diagram illustrating an analog-to-digital conversion system 100 according to embodiments of the subject technology. This diagram merely provides an example, which should not unduly limit the scope of the claims. One of ordinary skill in the art would recognize many variations, alternatives, and modifications. System 100 may be implemented as a SAR ADCs, discrete-time ADCs, NS-SAR ADCs, delta-sigma ADCs, pipelined ADCs, flash ADCs, hybrid ADCs, dual-slope ADCs, single-slope ADCs, and/or the like. Depending on the application, system 100 may incorporate various features such as oversampling, noise shaping, calibration, and/or the like.

System 100 may be applied to a wide range of applications, including health monitoring devices, industrial automation, and communication systems. For instance, in health-sensing devices such as wearable electronics, ADCs enable features like electrocardiogram (EKG) measurement, heart rate monitoring, and gesture recognition by converting analog signals generated by sensors into digital data for further analysis and processing. These digital outputs are then used to extract physiological parameters, such as heart rhythms or movement patterns, providing real-time feedback for medical or fitness applications.

In various implementations, system 100 employs a pipeline ADC architecture, which processes input signals in multiple stages to achieve high-resolution signal conversion. For instance, the signal conversion process may include a front-end stage and a back-end stage. The front-end stage performs coarse quantization of the input signal, generating an approximate digital representation. The back-end stage then refines this approximation through fine quantization to provide precise digital conversion.

In some embodiments, system 100 includes input terminal 101, which may be configured to receive an input signal (e.g., Vᵢₙ). For instance, the input signal may be an analog signal originating from a sensor, communication module, or other electronic components. The analog signal may represent physical or electrical measurements such as voltage levels, current levels, temperature data, or audio waveforms. For instance, the input signal may represent EKG signals in health sensing devices.

According to some examples, the input signal (e.g., Vᵢₙ) is processed by the front-end stage, which includes front-end ADC (FE-ADC) 102 and front-end digital-to-analog converter (FE-DAC) 104. For example, the term "digital-to-analog converter" may refer to a device or circuit that converts a discrete digital signal into a continuous analog signal. Examples of DACs may include, without limitation, binary weighted DACs, resistor-string DACs, R-2R ladder DACs, segmented DACs, delta-sigma DACs, pulse-width modulation (PWM) DACs, and/or the like. In some implementations, FE-ADC 102 is configured to perform an initial quantization of the input signal (e.g., Vᵢₙ) and generate a digital output signal (e.g., D_{out, fe}), which may represent a coarse approximation of the input signal. To refine this approximation, D_{out, fe} may be converted back to an analog signal by FE-DAC 104. In some cases, the output of FE-DAC 104 is subtracted from the original input signal Vᵢₙ by subtractor 103 to generate a residue voltage (e.g., Vᵣₑₛ). The residue voltage represents the difference between the original input signal Vᵢₙ and the coarse approximation provided by D_{out, fe}, and may be significantly smaller in magnitude than the original input signal.

In various embodiments, the residue voltage (e.g., Vᵣₑₛ) may be amplified by amplifier 105 before it is fed to back-end ADC (BE-ACD) 107 for subsequent processing. For example, the term "amplifier" may refer to may refer to a device or circuit that increases the amplitude of a signal. Examples of amplifiers may include, without limitation, operational amplifiers (op-amps), instrumentation amplifiers, differential amplifiers, programmable gain amplifiers, and/or the like. In some examples, amplifier 105 scales Vᵣₑₛ to a level suitable for fine quantization, relaxing the noise and linearity requirements for BE-ADC 107. BE-ADC 107 then processes the amplified residue voltage to generate a high-resolution digital output (e.g., D_{out, be}), which provides precise quantization of the finer details of the input signal.

In some implementations, the final digital output (e.g., Dₒᵤₜ) may be constructed by combining D_{out, fe} and D_{out, be}. To align the coarse and fine quantization, digital gain block 106 may be configured to scale D_{out, fe} by a gain factor G, which may be nominally equal to the gain of amplifier 105. This scaling ensures that the contribution from the coarse quantization matches the magnitude of the fine quantization for proper summation. The scaled coarse output and the fine output are then combined in adder 108 to generate the final digital output (e.g., Dₒᵤₜ), which represents the high-resolution digital approximation of the original input signal (e.g., Vᵢₙ).

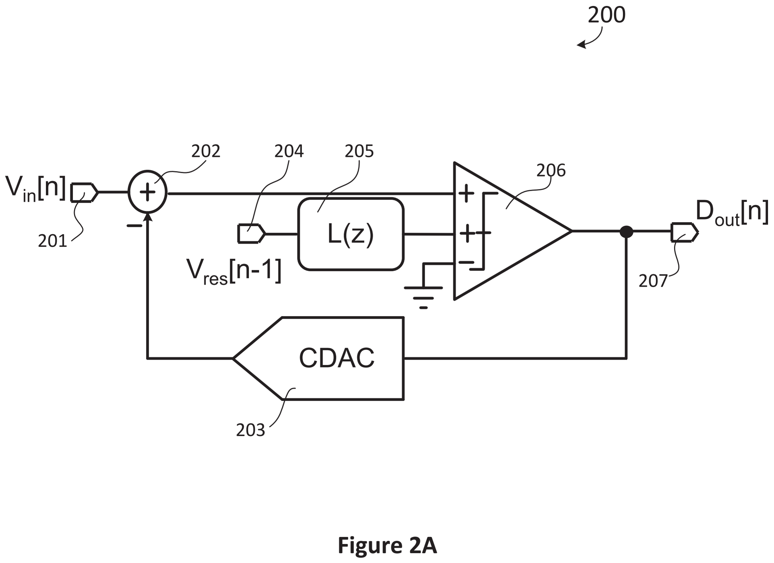

Figure 2A is a simplified diagram illustrating an analog-to-digital converter (ADC) 200 according to embodiments of the subject technology. This diagram merely provides an example, which should not unduly limit the scope of the claims. One of ordinary skill in the art would recognize many variations, alternatives, and modifications.

In some applications, ADC 200 may be implemented as a noise-shaped successive approximation register (NS-SAR) ADC and may be applied in various low-power, high-resolution applications, such as biomedical devices, IoT sensors, and communication systems. For instance, ADC 200 operates by performing a binary search to approximate the digital representation of the input signal, while simultaneously shaping quantization noise to improve in-band SNR.

As shown, ADC 200 may include input terminal 201 configured to receive an input signal (e.g., Vᵢₙ[n]), which may represent the sampled value of an analog signal at a specific instance in time. In some examples, ADC 200 further includes capacitive DAC (CDAC) 203, which serves as both an input sampling capacitor and a digital-to-analog converter for the SAR operation. In some aspects, the residue voltage (e.g., Vᵣₑₛ[n-1]) from the previous cycle may be processed by loop filter 205, which may be configured to provide in-band gain and out-of-band attenuation to enhance SNR within the signal band. This process shapes the quantization noise by reducing its power spectral density (PSD) within the signal band while allowing higher noise levels outside the signal band, which can be easily filtered in the digital domain.

According to various implementations, comparator 206 is configured to sum the residue voltage from CDAC 203 and the filtered residue voltage from loop filter 205. By combining these inputs, comparator 206 enables ADC 200 to shape noise components (e.g., quantization noise and/or comparator noise), improving the overall resolution and fidelity of the output signal (e.g., Dₒᵤₜ[n]) at output terminal 207. In some cases, the final digital output is generated by iteratively refining the approximation through the SAR logic, resulting in a high-resolution digital representation of the input signal.

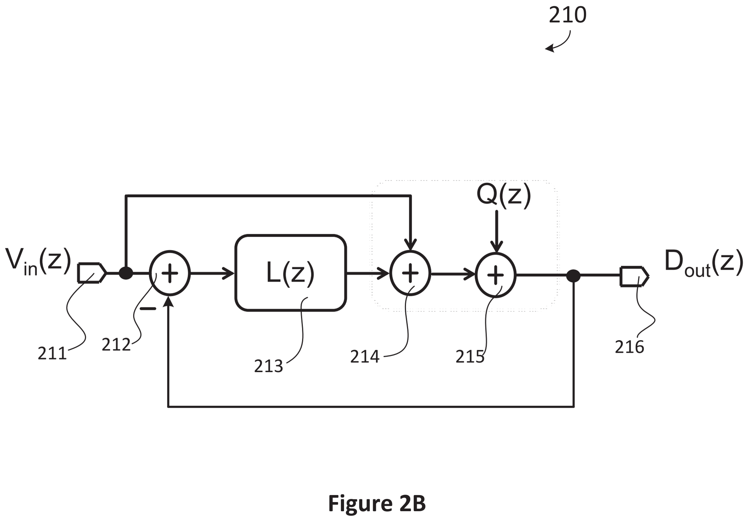

Figure 2B is a simplified diagram illustrating a signal flow within an analog-to-digital converter (ADC) according to embodiments of the subject technology. This diagram merely provides an example, which should not unduly limit the scope of the claims. One of ordinary skill in the art would recognize many variations, alternatives, and modifications.

As shown, signal flow 210 represents a z-domain model of an NS-SAR ADC (e.g., ADC 200 of Figure 2A), which leverages a feedback loop to shape quantization noise and enhance the SNR within the signal band. For instance, an input signal (e.g., Vᵢₙ(z)) is received at input terminal 211. Vᵢₙ(z) may correspond to the z-transform representation of the sampled signal input. The input signal may then be processed by subtraction block 212 (e.g., a CDAC) to generate a residue signal, which represents the difference between the input signal and its quantized approximation from previous cycles.

In some implementations, the residue voltage may be fed into loop filter 213, which applies in-band gain to amplify the signal of interest and out-of-band attenuation to suppress unwanted noise. Loop filter 213 plays an important role in shaping the quantization noise (e.g., Q(z)), as it reduces the PSD of the quantization noise within the signal band while allowing higher noise levels outside the signal band. The out-of-band noise can be easily filtered in the digital domain in subsequent processes. The initial residue voltage and the filtered residue voltage from loop filter 205 may be combined at summing node 214 (e.g., a comparator). Quantization noise (e.g., Q(z)) may be introduced at summing node 215, representing the effects of the quantization process.

In various embodiments, the final digital output (e.g., Dₒᵤₜ(z)) at output terminal 216 may be mathematically described by the following equation: ${D}_{out} \left(z\right) = {V}_{in} \left(z\right) + \frac{1}{1 + L \left(z\right)} Q \left(z\right)$ The term $\frac{1}{1 + L \left(z\right)} Q \left(z\right)$ represents the noise transfer function (NTF), which shapes the quantization noise as well as other noise sources-such as comparator noise and offset-by attenuating noise within the signal band while allowing higher noise levels outside the signal band. The term *Vᵢₙ*(*z*) represents signal transfer function (STF), which is ideally equal to 1, ensuring the input signal is passed through the system without distortion.

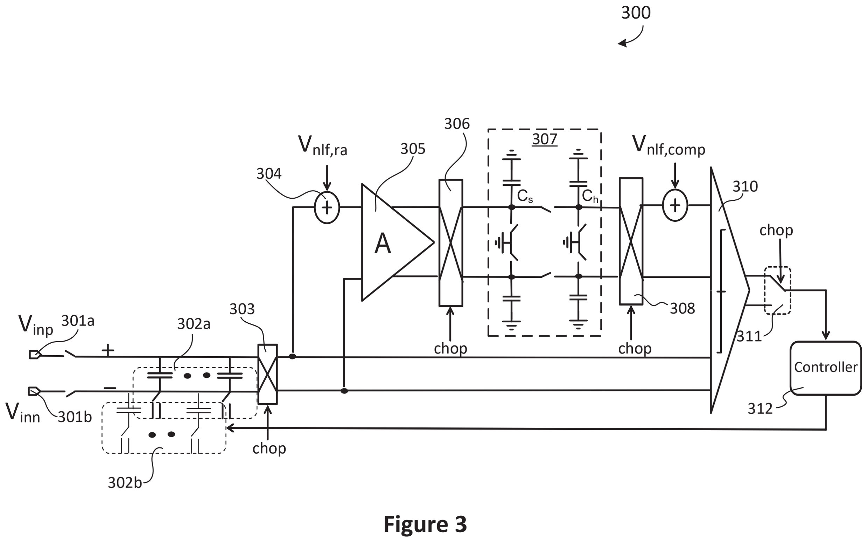

Figure 3 is a simplified diagram illustrating an analog-to-digital conversion system 300 according to embodiments of the subject technology. This diagram merely provides an example, which should not unduly limit the scope of the claims. One of ordinary skill in the art would recognize many variations, alternatives, and modifications.

As shown, system 300 may include an input terminal (e.g., 301a and/or 301b) configured to receive an input signal. For example, the term "input terminal" may refer to a physical or electrical interface configured to accept an external signal for processing within the system. Examples of input terminals may include, without limitation, physical pins, pads, connectors, wireless interfaces, and/or the like. In some cases, the input terminal may also include signal conditioning circuitry to prepare the signal for further processing. Depending on the application, the input signal may be analog. In some examples, the input signal may include a differential analog signal, which includes two complementary components, such as Vᵢₙₚ and Vᵢₙₙ. For instance, system 300 may include input terminal 301a configured to receive Vᵢₙₚ and input terminal 301b configured to receive Vᵢₙₙ.

In some examples, system 300 may function as a back-end ADC in a pipeline ADC architecture. In such cases, the input signal received by system 300 may be generated from a front-end stage, which performs coarse quantization of the original analog input. For instance, the front-end stage may resolve the most significant bits (MSBs) of the input signal and generate a residue voltage, which is then passed to the back-end ADC (e.g., system 300) as an input for fine quantization to resolve the remaining bits and achieve high-resolution digital conversion.

In various implementations, system 300 further includes one or more converters coupled to the input terminal. For example, the term "converter" may refer to a circuit or system that transforms a signal from one form to another, such as from analog to digital or vice versa. Examples of converters may include, without limitation, capacitive digital-to-analog converters (CDACs), resistor-based DACs, delta-sigma modulators, and/or the like.

As an example, system 300 may include converter 302a coupled to input terminal 301a, and converter 302b coupled to input terminal 301b. These converters are configured to process the input signal (e.g., Vᵢₙₚ and Vᵢₙₙ) received at the input terminals. In some implementations, the converters may be implemented as CDACs. For instance, the term "capacitive digital-to-analog converter" may refer to a circuit or device that uses an array of capacitors to convert a digital code into an analog voltage. CDACs operate by sampling an analog input signal, holding the sampled signal, and generating an analog output based on a digital input code.

In some embodiments, the converters 302a and 302b are configured to generate a first signal based at least on the input signal. For instance, the CDAC may sample the input signal (e.g., Vᵢₙₚ and Vᵢₙₙ) during the sampling phase and store the sampled voltage on its capacitor array. During the conversion phase, the CDAC compares the stored charge to a reference voltage and generates a residue voltage representing the difference between the input signal and its coarse quantization. For instance, the first signal includes a residue voltage, which may be associated with the difference between the input signal and the coarse quantization result obtained during the initial stages of conversion. In other words, the residue voltage represents the "remaining" portion of the input signal that has not yet been quantized at the front-end stage, and it is passed to subsequent stages (e.g., back-end stage) for fine quantization to achieve higher resolution.

In various implementations, system 300 further includes amplifier 305, which may be coupled to converter 302a and/or converter 302b. Amplifier 305 may be configured to process the first signal generated by the converters. For instance, amplifier 305 is configured to generate a second signal by amplifying the first signal. In some cases, amplifier 305 scales the residue voltage to a level suitable for fine quantization in the subsequent stages. However, amplifier 305 may introduce low-frequency noise, which may degrade the performance of the system if not properly managed. For example, the term "low-frequency noise" may refer to noise components that occur at frequencies typically below 10 kHz and may include flicker noise, drift, and/or the like. Flicker noise may arise from imperfections in the semiconductor material and can be exacerbated by factors such as temperature variations and device aging. Low-frequency noise is particularly problematic in amplifiers because its power spectral density increases as frequency decreases, making it dominant in the low-frequency range.

In some examples, the second signal may contain both a signal component and a noise component, each occupying different frequency regions. For example, the signal component falls within a band of interest and represents the amplified residue voltage, which carries useful information for fine quantization in subsequent processing stages. The noise component includes low-frequency noise and quantization noise introduced during amplification and conversion. In some examples, the second signal may include a first component (e.g., V_{nlf,ra}) characterized by a first frequency. For instance, the first component may comprise a noise component, and the first frequency may fall within a range of approximately 1 to 10 kHz. Without proper mitigation, the noise can degrade the SNR and reduce the accuracy of the analog-to-digital conversion.

In various implementations, system 300 further includes filter 307, which may be coupled to amplifier 305. For example, the term "filter" may refer to a circuit or device configured to shape the signal by attenuating certain frequencies while preserving others. Examples of filters may include, without limitation, low-pass filters, high-pass filters, band-pass filters, and/or the like. Filter 307 may be configured to process the second signal by spectral shaping. Filter 307 enhances SNR and minimizes unwanted quantization noise within the signal band. The term "noise shaping" may refer to any signal processing techniques used to modify a signal's noise spectrum. Examples of noise-shaping techniques may include oversampling, delta-sigma modulation, loop filtering, spectral shaping, and/or the like. Depending on the implementation, filters may be implemented using passive elements (e.g., resistors, capacitors, and inductors), active components (e.g., operational amplifiers), and/or the like. In some examples, filter 307 is configured to generate a third signal by spectrally shaping the second signal. For instance, filter 307 shapes the amplified signal by providing in-band gain and out-of-band attenuation, reducing quantization noise within the signal band.

In some embodiments filter 307 includes an integrator, which may be configured to accumulate the amplified residue voltage over one or more sampling cycles. The integrator may perform a mathematical summation of the signal, emphasizing low-frequency components while attenuating high-frequency variations. In some aspects, filter 307 includes a low-pass filter, which selectively attenuates high-frequency noise while preserving the lower-frequency components of the signal. By controlling the filter's cutoff frequency, system 300 ensures that quantization noise remains outside the desired signal band, thus improving overall system fidelity.

According to some embodiments, system 300 further includes comparator 310, which may be coupled to filter 307. For example, the term "comparator" may refer to a circuit or device that compares two or more input signals and generates an output based on their differences. Comparators may be used in analog-to-digital conversion to determine the relative magnitude of signals and make binary decisions based on threshold comparisons. Examples of comparators may include, without limitation, operational amplifier-based comparators, differential comparators, window comparators, digital comparators, and/or the like.

In various implementations, comparator 310 is configured to process the filtered signal by performing summation and/or comparison operations. For example, comparator 310 is configured to generate an output signal by comparing the third signal against a reference level. The output signal represents the results of the comparison. In some cases, the output signal includes a binary signal (e.g., 0 or 1). In some aspects, comparator 310 may also perform summation by incorporating inputs from different signal paths. For example, in an NS-SAR ADC, comparator 310 may sum the filtered residue voltage from filter 307 with the quantized feedback signal before making a decision. This summation operation enables noise shaping, improving in-band SNR and enhancing resolution. However, similar to amplifier 305, comparator 310 may also introduce low-frequency noise (e.g., V_{nlf,comp}), which may negatively impact ADC resolution by increasing decision uncertainty, leading to conversion errors. For instance, the third signal includes a second component (e.g., a low-frequency noise) characterized by a second frequency lower than the first chopping frequency.

To address low-frequency noise introduced by amplifier 305 and comparator 310, chopping techniques may be employed. Chopping modulates low-frequency noise to a higher frequency, where it can be more easily filtered. In various embodiments, system 300 may include one or more switching elements that are used to implement chopping at different stages of the signal path. For example, the term "switching element" may refer to a circuit or device used to control the connection, polarity, or modulation of a signal. Depending on the application, switching elements can be implemented using transistors, MOSFETs, transmission gates, or other switching components.

In some embodiments, first switching element 303 may be coupled to the converter (e.g., converter 302a and/or 302b) and/or amplifier 305. For instance, first switching element 303 may be coupled to an output of the converter and an input of the amplifier. In some examples, first switching element 303 may be configured to modulate the first signal by converting the first component (e.g., a low-frequency noise) to a first chopping frequency higher than the first frequency. For instance, the term "chopping frequency" may refer to a certain frequency at which a switching element modulates a signal or noise component, upconverting its spectral content to a higher frequency. In some implementations, first switching element 303 periodically inverts the polarity of the first signal at the first chopping frequency, effectively shifting the signal and its associated low-frequency noise to a higher frequency band, where it can be filtered out by subsequent stages, such as a low-pass filter or demodulator.

In some implementations, the chopping frequency may be determined based on system requirements to ensure that noise components are shifted well beyond the band of interest. For example, the first chopping frequency may range from approximately 10 kHz to 500 kHz, depending on the implementation. As an example, in health-sensing systems, a chopping frequency of 20 kHz to 100 kHz may be selected to avoid interference with the physiological signal band. In higher bandwidth applications, the chopping frequency may be set as high as 200 kHz to 500 kHz to accommodate faster sampling rates. In some cases, the ratio between the chopping frequency (e.g., the first chopping frequency) and the frequency of the noise component (e.g., the first frequency) may be greater than or equal to 10, ensuring that the noise spectrum is shifted sufficiently far from the in-band signal for effective removal.

In some embodiments, second switching element 306 may be coupled to amplifier 305 and/or filter 307. Second switching element 306 may be configured to demodulate (or dechop) the second signal at the first chopping frequency. For instance, the term "demodulation" or "demodulate" may refer to a process in which a previously modulated signal is restored to its original form by removing or reversing the modulation. In some examples, second switching element 306 may be coupled to an output of amplifier 305 and/or an input of filter 307, where it functions to restore the polarity of the signal that was previously modulated by first switching element 303. By demodulating the signal, second switching element 306 allows the signal to return to its original form, free from the modulated noise components that were shifted to higher frequencies. In other aspects, second switching element 306 may enable amplified residue sampling on capacitor Cₛ, which may be configured to store and then accumulate the amplified residue voltage over Cₕ over one or more sampling cycles.

According to various implementations, third switching element 308 may be coupled to filter 307 and/or comparator 310. Third switching element 308 may be configured to modulate the third signal by converting the second component to the first chopping frequency. This modulation process is beneficial for suppressing the low-frequency noise (e.g., the second component) introduced by comparator 310, which can degrade ADC resolution if left unaddressed.

In some examples, fourth switching element 311 may be coupled to comparator 310 and configured to demodulate the third signal at the first chopping frequency. For instance, fourth switching element 311 may be coupled to an output of comparator 310. This demodulation process ensures that any residual modulation introduced by previous switching elements is reversed before the signal undergoes subsequent digital processing. By restoring the signal to its original polarity, fourth switching element 311 allows comparator 310 to process a clean signal while maintaining the noise-reduction benefits introduced by chopping. In some cases, fourth switching element 311 may include a multiplexer, which is configured to selectively switch between different input signal paths during demodulation.

System 300 implements block-level chopping to mitigate low-frequency noise originating from key noise-contributing circuit blocks (e.g., amplifier 305 and comparator 310). By applying chopping locally at these circuit blocks rather than at the system level, system 300 eliminates unwanted interaction with quantization noise and shaped CDAC mismatch errors, effectively suppressing low-frequency noise and offset drift. By selecting appropriate chopping frequencies at different stages of the signal path, system 300 can optimize noise rejection while minimizing any undesired mixing of high-frequency noise components into the signal band.

In various implementations, system 300 further includes controller 312, which may be coupled to comparator 310. For example, the term "controller" may refer to a processing unit or logic circuit configured to manage the operation of multiple components in the system. Examples of controllers may include, without limitation, state machines, microcontrollers, digital logic circuits, digital signal processors, field-programmable gate arrays (FPGAs), and/or the like. Depending on the application, controller 312 may include NS-SAR logic, digital error modulation (DEM) logic, and/or other digital processing circuits used in ADC architectures.

In some embodiments, controller 312 is configured to process the output of comparator 310 (e.g., the output signal) and generate a digital representation of the input signal. For instance, in an NS-SAR ADC, controller 312 executes the successive approximation algorithm, adjusting control signals sent to converters 302a and/or 302b to refine the digital conversion process. The NS-SAR logic works in conjunction with noise-shaping techniques, ensuring that quantization noise is shaped efficiently across multiple sampling cycles. In some examples, controller 312 may also regulate the timing and coordination of the chopping sequence, ensuring that switching elements (e.g., 303, 306, 308, and/or 311) operate in sync to maintain effective noise suppression.

While the above is a full description of the specific embodiments, various modifications, alternative constructions and equivalents may be used. Therefore, the above description and illustrations should not be taken as limiting the scope of the subject technology which is defined by the appended claims.

The following are further embodiments of the invention:
1. An apparatus comprising:
   an input terminal configured to receive an input signal;
   a converter coupled to the input terminal, the converter being configured to generate a first signal based at least on the input signal;
   an amplifier coupled to the converter, the amplifier being configured to generate a second signal by amplifying the first signal, the second signal comprising a first component characterized by a first frequency;
   a first switching element coupled to the converter and the amplifier, the first switching element being configured to modulate the first signal by converting the first component to a first chopping frequency higher than the first frequency;
   a filter coupled to the amplifier, the filter being configured to generate a third signal by applying noise shaping to the second signal; and
   a comparator coupled to the filter, the comparator being configured to generate an output signal by comparing a sum of the first and third signals to a reference level.
2. The apparatus of embodiment 1, further comprising a second switching element coupled to the amplifier, the second switching element being configured to demodulate the second signal at the first chopping frequency.
3. The apparatus of embodiment 1, wherein the third signal comprises a second component characterized by a second frequency lower than the first chopping frequency.
4. The apparatus of embodiment 3, further comprising a third switching element coupled to the filter and the comparator, the third switching element being configured to modulate the third signal by converting the second component to the first chopping frequency.
5. The apparatus of embodiment 4, further comprising a fourth switching element coupled to the comparator and configured to demodulate the third signal at the first chopping frequency.
6. The apparatus of embodiment 5, wherein the fourth switching element comprises a multiplexer.
7. The apparatus of embodiment 1, further comprising a controller coupled to the comparator, the controller being configured to generate a digital representation of the input signal based at least on the output signal.
8. The apparatus of embodiment 1, wherein the first signal is associated with a difference between the input signal and a first approximation of the input signal.
9. The apparatus of embodiment 1, wherein the filter further comprises an integrator configured to accumulate the second signal over one or more cycles.
10. An apparatus comprising:
   an input terminal configured to receive an input signal;
   a converter coupled to the input terminal, the converter being configured to generate a first signal based at least on the input signal;
   an amplifier coupled to the converter, the amplifier being configured to generate a second signal by amplifying the first signal, the second signal comprising a first component characterized by a first frequency;
   a first switching element coupled to the converter and the amplifier, the first switching element being configured to modulate the first signal by converting the first component to a first chopping frequency higher than the first frequency;
   a filter coupled to the amplifier, the filter being configured to generate a third signal based at least on the second signal; and
   a comparator coupled to the filter, the comparator being configured to generate an output signal by comparing a sum of the first and third signals to a reference level.
11. The apparatus of embodiment 10, further comprising a second switching element coupled to the amplifier, the second switching element being configured to demodulate the second signal at the first chopping frequency.
12. The apparatus of embodiment 10, wherein the third signal comprises a second component characterized by a second frequency lower than the first chopping frequency.
13. The apparatus of embodiment 12, further comprising a third switching element coupled to the filter and the comparator, the third switching element being configured to modulate the third signal by converting the second component to the first chopping frequency.
14. The apparatus of embodiment 13, further comprising a fourth switching element coupled to the comparator and configured to demodulate the third signal at the first chopping frequency.
15. The apparatus of embodiment 10, further comprising a controller coupled to the comparator, the controller being configured to generate a digital representation of the input signal based at least on the output signal.
16. The apparatus of embodiment 10, wherein the first signal is associated with a difference between the input signal and a first approximation of the input signal.
17. An apparatus comprising:
   an input terminal configured to receive an input signal;
   a converter coupled to the input terminal, the converter being configured to generate a first signal based at least on the input signal;
   an amplifier coupled to the converter, the amplifier being configured to generate a second signal by amplifying the first signal, the second signal comprising a first component characterized by a first frequency;
   a first switching element coupled to the converter and the amplifier, the first switching element being configured to modulate the first signal by converting the first component to a first chopping frequency higher than the first frequency;
   a filter coupled to the amplifier, the filter being configured to generate a third signal based at least on the second signal;
   a comparator coupled to the filter, the comparator being configured to generate an output signal by comparing a sum of the first and third signals to a reference level; and
   a second switching element coupled to the comparator and configured to demodulate the third signal at the first chopping frequency.
18. The apparatus of embodiment 17, further comprising a controller coupled to the comparator, the controller being configured to generate a digital representation of the input signal based at least on the output signal.
19. The apparatus of embodiment 17, wherein the second switching element comprises a multiplexer.
20. The apparatus of embodiment 17, wherein the first signal is associated with a difference between the input signal and a first approximation of the input signal.

## Claims

1. An apparatus comprising:
an input terminal configured to receive an input signal;
a converter coupled to the input terminal, the converter being configured to generate a first signal based at least on the input signal;
an amplifier coupled to the converter, the amplifier being configured to generate a second signal by amplifying the first signal, the second signal comprising a first component **characterized by** a first frequency;
a first switching element coupled to the converter and the amplifier, the first switching element being configured to modulate the first signal by converting the first component to a first chopping frequency higher than the first frequency;
a filter coupled to the amplifier, the filter being configured to generate a third signal by applying noise shaping to the second signal; and
a comparator coupled to the filter, the comparator being configured to generate an output signal by comparing a sum of the first and third signals to a reference level.

2. The apparatus of claim 1, wherein the first signal is associated with a difference between the input signal and a first approximation of the input signal.

3. The apparatus of claims 1 or 2, wherein the filter further comprises an integrator configured to accumulate the second signal over one or more cycles.

4. An apparatus comprising:
an input terminal configured to receive an input signal;
a converter coupled to the input terminal, the converter being configured to generate a first signal based at least on the input signal;
an amplifier coupled to the converter, the amplifier being configured to generate a second signal by amplifying the first signal, the second signal comprising a first component **characterized by** a first frequency;
a first switching element coupled to the converter and the amplifier, the first switching element being configured to modulate the first signal by converting the first component to a first chopping frequency higher than the first frequency;
a filter coupled to the amplifier, the filter being configured to generate a third signal based at least on the second signal; and
a comparator coupled to the filter, the comparator being configured to generate an output signal by comparing a sum of the first and third signals to a reference level.

5. The apparatus of one of the preceding claims, further comprising a second switching element coupled to the amplifier, the second switching element being configured to demodulate the second signal at the first chopping frequency.

6. The apparatus of one of the preceding claims, wherein the third signal comprises a second component **characterized by** a second frequency lower than the first chopping frequency.

7. The apparatus of claims 5 or 6, further comprising a third switching element coupled to the filter and the comparator, the third switching element being configured to modulate the third signal by converting the second component to the first chopping frequency.

8. The apparatus of claim 7, further comprising a fourth switching element coupled to the comparator and configured to demodulate the third signal at the first chopping frequency.

9. The apparatus of claim 8, wherein the fourth switching element comprises a multiplexer.

10. The apparatus of claims 1 or 4, further comprising a controller coupled to the comparator, the controller being configured to generate a digital representation of the input signal based at least on the output signal.

11. The apparatus of one of the preceding claims, wherein the first signal is associated with a difference between the input signal and a first approximation of the input signal.

12. An apparatus comprising:
an input terminal configured to receive an input signal;
a converter coupled to the input terminal, the converter being configured to generate a first signal based at least on the input signal;
an amplifier coupled to the converter, the amplifier being configured to generate a second signal by amplifying the first signal, the second signal comprising a first component **characterized by** a first frequency;
a first switching element coupled to the converter and the amplifier, the first switching element being configured to modulate the first signal by converting the first component to a first chopping frequency higher than the first frequency;
a filter coupled to the amplifier, the filter being configured to generate a third signal based at least on the second signal;
a comparator coupled to the filter, the comparator being configured to generate an output signal by comparing a sum of the first and third signals to a reference level; and
a second switching element coupled to the comparator and configured to demodulate the third signal at the first chopping frequency.

13. The apparatus of claim 12, further comprising a controller coupled to the comparator, the controller being configured to generate a digital representation of the input signal based at least on the output signal.

14. The apparatus of claim 12, wherein the second switching element comprises a multiplexer.

15. The apparatus of claim 12, wherein the first signal is associated with a difference between the input signal and a first approximation of the input signal.
